# EUROPEAN PATENT APPLICATION

(11) **EP 4 749 684 A1**
(43) Date of publication of application: **27.05.2026**
(21) Application number: 23945602.3
(22) Date of filing: 10.10.2023
(51) Int. Cl.: H01L 21/67, H01L 21/56, H01L 21/66, G01V 8/10

(54) **SEMICONDUCTOR PLASTIC PACKAGING SYSTEM AND FOREIGN OBJECT DETECTION METHOD**

(30) Priority: 17.07.2023 CN 202310878511
(71) Applicant: Diodes Shanghai Co., Ltd., Songjiang District, Shanghai 201612 (CN); Diodes Technology (Chengdu) Company Limited, Chengdu, Sichuan 611731 (CN); Shanghai Kaihong Electronic Company Limited, Shanghai 201612 (CN)
(72) Inventor: WANG, Desen, Chengdu, Sichuan 611731 (CN); FENG, Zhigang, Chengdu, Sichuan 611731 (CN)
(74) Representative: Marks & Clerk LLP
(86) International application number: PCT/CN2023/123710
(87) International publication number: WO 2025/015721

(57) **Abstract**

A semiconductor plastic packaging system and a foreign object detection method. The semiconductor plastic packaging system comprises a plastic packaging device and a foreign object detection apparatus. The foreign object detection apparatus comprises an image collector and a controller. The image collector is used for collecting a target image of a lead frame to be subjected to plastic packaging located in a loading region. The loading region is located in the plastic packaging device. The controller is used for presetting a standard image, comparing the target image with the standard image, and determining whether a foreign object is present in a non-plastic packaging region of the target image. In the present application, the image collector can collect an image of the lead frame to be subjected to plastic packaging before plastic packaging, and the controller compares, with the standard image, the image of the lead frame to be subjected to plastic packaging before plastic packaging and performs analysis to identify whether a foreign object is present in the non-plastic packaging region. The foreign object detection process is automatically completed without manual operation, and thus, labor costs can be saved. Moreover, any contact with the lead frame to be subjected to plastic packaging is avoided during the detection process, thereby avoiding causing other abnormalities, during testing, in the lead frame to be subjected to plastic packaging.

## Description

The present application claims priority to the Chinese Patent Application No. 202310878511.2, titled "SEMICONDUCTOR PLASTIC PACKAGING SYSTEM AND FOREIGN OBJECT DETECTION METHOD", filed on July 17, 2023 with the China National Intellectual Property Administration, which is incorporated herein by reference in its entirety.

### FIELD

The present disclosure relates to the field of packaging, and in particular relates to a semiconductor plastic packaging system and a foreign object detection method.

### BACKGROUND

Before a plastic packaging process in semiconductor packaging (for example, after a lead frame undergoes a lead bonding process), issues such as chip displacement and adherence by a foreign material may occur. These foreign objects, including the displaced chip and the adhering foreign material, may lead to problems during the plastic packaging process, such as mold clamping failure, surface damage to a plastic packaging mold, product flash, and pin deformation during a mold clamping process. Annually, damage to a plastic packaging mold results in high mold costs, causing significant financial losses.

Currently, to avoid adverse effects of foreign objects on lead frames regarding product quality and mold costs, manual inspection is performed on to-be-plastic-packaged lead frames to reject lead frames with foreign objects on the surface. However, the manual inspection increases labor costs, and improper operation during manual inspection may cause more damage.

Therefore, a focus for those skilled in the art is how to address the above technical issue.

### SUMMARY

The purpose of the present disclosure is to provide a semiconductor plastic packaging system and a foreign object detection method, to reduce labor costs and avoid causing other anomalies to a to-be-plastic-packaged lead frame during detection.

To address the above technical issue, a semiconductor plastic packaging system is provided according to the present disclosure, and the semiconductor plastic packaging system includes a plastic packaging device and a foreign object detection apparatus. The foreign object detection apparatus includes an image capturing device and a controller.

The image capturing device is configured to capture a target image of a to-be-plastic-packaged lead frame located in a loading region, where the loading region is located in the plastic packaging device.

The controller is configured to preset a standard image, and compare the target image with the standard image to determine whether a foreign object is present in a non-plastic packaging region of the target image.

In an embodiment, the controller is configured to determine the non-plastic packaging region from the target image and perform comparison with the standard image.

In an embodiment, the controller is configured to compare the non-plastic packaging region of the target image with a non-plastic packaging region of the standard image.

In an embodiment, the controller is connected to a switch component of the plastic packaging device, and in response to the foreign object being present in the non-plastic packaging region of the target image, the controller is further configured to send a shutdown instruction to the switch component to control the plastic packaging device to be shut down.

In an embodiment, the semiconductor plastic packaging system further includes:
an alarm device connected to the controller, where the alarm device is configured to receive an alarm instruction from the controller and issue an alarm in response to the foreign object being present in the non-plastic packaging region of the target image.

In an embodiment, the semiconductor plastic packaging system further includes:
a display apparatus connected to the controller, where the display apparatus is configured to display the target image and a determination result.

In an embodiment, a resolution of the image capturing device is above 20 million pixels.

A foreign object detection method before semiconductor plastic packaging is provided according to the present disclosure. The foreign object detection method includes:
obtaining a target image of a to-be-plastic-packaged lead frame located in a loading region of a plastic packaging device; and
comparing the target image with a standard image to determine whether a foreign object is present in a non-plastic packaging region of the target image.

In an embodiment, the foreign object detection method further includes:
in response to the foreign object being present in the non-plastic packaging region of the target image, sending a shutdown instruction to a switch component of the plastic packaging device to control the plastic packaging device to be shut down.

In an embodiment, the foreign object detection method further includes:
in response to the foreign object being present in the non-plastic packaging region of the target image, sending an alarm instruction to an alarm device to cause the alarm device to issue an alarm.

In an embodiment, the foreign object detection method further includes:
sending the target image and a determination result to a display apparatus.

In an embodiment, the comparing the target image with a standard image to determine whether a foreign object is present in a non-plastic packaging region of the target image includes:
locating a frame connecting rib of the to-be-plastic-packaged lead frame in the target image to determine the non-plastic packaging region; and
comparing the non-plastic packaging region of the target image with the standard image to determine whether the foreign object is present in the non-plastic packaging region.

The semiconductor plastic packaging system according to the present disclosure includes the plastic packaging device and the foreign object detection apparatus. The foreign object detection apparatus includes the image capturing device and the controller. The image capturing device is configured to capture the target image of the to-be-plastic-packaged lead frame located in the loading region, where the loading region is located in the plastic packaging device. The controller is configured to preset the standard image, and compare the target image with the standard image to determine whether a foreign object is present in the non-plastic packaging region of the target image.

It can be seen that the semiconductor plastic packaging system in the present disclosure includes the plastic packaging device and the foreign object detection apparatus. The image capturing device in the foreign object detection apparatus may capture the target image of the to-be-plastic-packaged lead frame located in the loading region, that is, an image of the to-be-plastic-packaged lead frame before plastic packaging. The controller may perform a comparative analysis between the target image of the to-be-plastic-packaged lead frame before plastic packaging and the standard image to determine whether the foreign object is present in the non-plastic packaging region. The foreign object detection is automatically completed without manual operation, thus saving labor costs. Moreover, any contact with the to-be-plastic-packaged lead frame is avoided during the foreign object detection, and other anomalies in the to-be-plastic-packaged lead frame are avoided during the foreign object detection.

Furthermore, a foreign object detection method having the aforementioned advantages is further provided according to the present disclosure.

### BRIEF DESCRIPTION OF THE DRAWINGS

Hereinafter drawings to be applied in embodiments of the present disclosure or in the conventional technology are briefly described, in order to illustrate technical solutions according to embodiments of the present disclosure or in the conventional technology more clearly. Apparently, the drawings in the following descriptions are only some embodiments of the present disclosure, and other drawings may be obtained by those skilled in the art based on the provided drawings without any creative effort.
FIG. 1 is a first schematic structural diagram of a semiconductor plastic packaging system according to an embodiment of the present disclosure;
FIG. 2 is a schematic diagram of an image of a to-be-plastic-packaged lead frame when the to-be-plastic-packaged lead frame is a no good (NG) product according to an embodiment of the present disclosure;
FIG. 3 is a schematic diagram of an image of a to-be-plastic-packaged lead frame when the to-be-plastic-packaged lead frame is a good product according to an embodiment of the present disclosure;
FIG. 4 is a second schematic structural diagram of a semiconductor plastic packaging system according to an embodiment of the present disclosure;
FIG. 5 is a first flowchart of a foreign object detection method applied to a semiconductor plastic packaging system according to an embodiment of the present disclosure;
FIG. 6 is a second flowchart of a foreign object detection method applied to a semiconductor plastic packaging system according to an embodiment of the present disclosure; and
FIG. 7 is a schematic diagram of a target image of a to-be-plastic-packaged lead frame according to an embodiment of the present disclosure.

In the figures, 1 represents a plastic packaging device, 2 represents a foreign object detection apparatus, 21 represents an image capturing device, 22 represents a controller, and 3 represents an alarm device.

### DETAILED DESCRIPTION

The present disclosure is described in detail in conjunction with the drawings and the embodiments hereinafter, so as to facilitate those skilled in the art to better understand the solutions according to the present disclosure. Apparently, the described embodiments are only some rather than all of the embodiments of the present disclosure. Based on the embodiments of the present disclosure, all other embodiments obtained by those skilled in the art without any creative work fall into the protection scope of the present disclosure.

Hereinafter various details are illustrated in description to facilitate full understanding of the present disclosure. The present disclosure may be implemented in a manner other than those described herein. Those skilled in the art may deduce by analogy without departing from a concept of the present disclosure. Hence, the present disclosure is not limited to specific embodiments disclosed herein.

As described in the background section, currently manual inspection is performed on to-be-plastic-packaged lead frames to reject lead frames with foreign objects on the surface. However, the manual inspection increases labor costs, and improper operation during manual inspection may cause more damage.

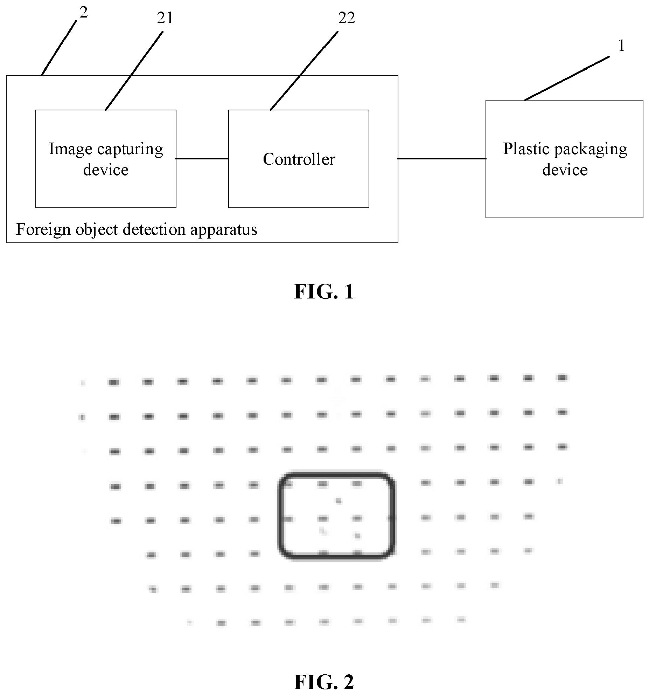

In view of this, a semiconductor plastic packaging system is provided according to the present disclosure. Referring to FIG. 1, the system includes a plastic packaging device 1 and a foreign object detection apparatus 2, where the foreign object detection apparatus 2 includes an image capturing device 21 and a controller 22.

The image capturing device 21 is configured to capture a target image of a to-be-plastic-packaged lead frame located in a loading region, where the loading region is located in the plastic packaging device 1.

The controller 22 is configured to preset a standard image, and compare the target image with the standard image to determine whether a foreign object is present in a non-plastic packaging region of the target image.

A structure of the plastic packaging device 1 in this embodiment may refer to a plastic packaging device 1 for plastic packaging of a lead frame in the related art, which is not described in detail in this embodiment.

The image capturing device 21 may be arranged in the loading region of the plastic packaging device 1. The loading region of the plastic packaging device 1 includes a loading track, and the to-be-plastic-packaged lead frame is arranged on the loading track and waits for plastic packaging. The image capturing device 21 may be a device capable of capturing images, such as a camera or a camcorder, which is not specifically limited in this embodiment.

To improve the accuracy of foreign object detection, a resolution of the image capturing device 21 is above 20 million pixels, and the accuracy of detection reaches 0.1mm×0.1mm.

The target image is captured through the image capturing device 21 and is transmitted to the controller 22 via wireless transmission or wired transmission. When the wireless transmission is adopted, the image capturing device 21 may internally integrate a wireless transmission component, or the foreign object detection apparatus 2 may further include a wireless transmission component connected to the image capturing device 21 and the controller 22. The wireless transmission component may be a Bluetooth transmission component, a WiFi transmission component, or the like.

The controller 22 includes, but is not limited to, a single-chip microcomputer or a microcontroller unit (MCU).

In an embodiment, a process of the controller 22 comparing the target image of the to-be-plastic-packaged lead frame with the standard image includes:
locating a frame connecting rib of the to-be-plastic-packaged lead frame in the target image of the to-be-plastic-packaged lead frame to determine the non-plastic packaging region; and comparing the non-plastic packaging region of the target image with the standard image to determine whether the foreign object is present in the non-plastic packaging region.

That is, the controller determines the non-plastic packaging region from the target image and performs comparison with the standard image.

Herein, before locating the frame connecting rib in the target image of the to-be-plastic-packaged lead frame, the process may further include: visual localization for determining the to-be-plastic-packaged lead frame in an image.

In another embodiment, the process of the controller 22 comparing the target image of the to-be-plastic-packaged lead frame with the standard image includes: the controller comparing the non-plastic packaging region of the target image with a non-plastic packaging region of the standard image.

The standard image is an image of a lead frame without any foreign objects (such as displaced or scattered chips or adhering foreign materials).

In an embodiment, the semiconductor plastic packaging system further includes:
a display apparatus connected to the controller 22, where the display apparatus is configured to display the target image and a determination result.

The determination result includes two cases: one is that the foreign object is present on the to-be-plastic-packaged lead frame, and the other is that no foreign object is present on the to-be-plastic-packaged lead frame.

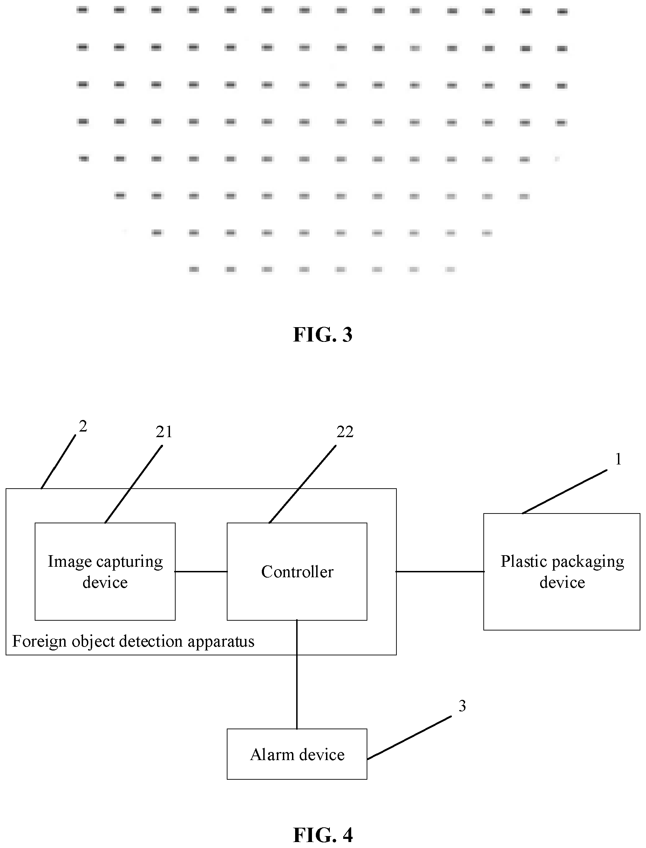

In the case that the foreign object is present on the to-be-plastic-packaged lead frame, as shown in FIG. 2, the foreign object is present within the box in FIG. 2, and the to-be-plastic-packaged lead frame is a no good (NG) product. In the case that no foreign object is present on the to-be-plastic-packaged lead frame, as shown in FIG. 3, the to-be-plastic-packaged lead frame is a good product.

The semiconductor plastic packaging system in the embodiment includes the plastic packaging device 1 and the foreign object detection apparatus 2. The image capturing device 21 in the foreign object detection apparatus 2 may capture the target image of the to-be-plastic-packaged lead frame located in the loading region, that is, an image of the to-be-plastic-packaged lead frame before plastic packaging. The controller 22 may perform a comparative analysis between the target image of the to-be-plastic-packaged lead frame before plastic packaging and the standard image to determine whether the foreign object is present in the non-plastic packaging region. The foreign object detection is automatically completed without manual operation, thus saving labor costs. Moreover, any contact with the to-be-plastic-packaged lead frame is avoided during the foreign object detection, and other anomalies in the to-be-plastic-packaged lead frame are avoided during the foreign object detection.

Based on the above embodiments, in an embodiment of the present disclosure, the controller 22 is connected to a switch component of the plastic packaging device 1. In response to the foreign object being present in the non-plastic packaging region of the target image, the controller 22 is further configured to send a shutdown instruction to the switch component to control the plastic packaging device 1 to be shut down.

The controller 22 may communicate with the switch component of the plastic packaging device 1. In response to the foreign object being present on the to-be-plastic-packaged lead frame, the controller 22 may automatically shut down the plastic packaging device 1, so that personnel handle the to-be-plastic-packaged lead frame with the foreign object and clear the foreign object, thereby ensuring that a mold is not damaged.

Referring to FIG. 4, based on any of the above embodiments, in an embodiment of the present disclosure, the semiconductor plastic packaging system further includes:
an alarm device 3 connected to the controller 22, where the alarm device 3 is configured to receive an alarm instruction from the controller 22 and issue an alarm in response to the foreign object being present in the non-plastic packaging region of the target image.

It should be noted that the alarm device 3 in this embodiment may be additionally arranged, or may be arranged in the semiconductor plastic packaging system.

The alarm device 3 may be any one or any combination of a sound alarm device, a light alarm device, and a text alarm device.

In this embodiment, in response to the foreign object being present on the to-be-plastic-packaged lead frame, the controller 22 controls the alarm device 3 to issue the alarm to timely notify the personnel that the foreign object is present on the to-be-plastic-packaged lead frame, so that the personnel handle the to-be-plastic-packaged lead frame with the foreign object in the loading region and clear the foreign object, thereby ensuring that the mold is not damaged.

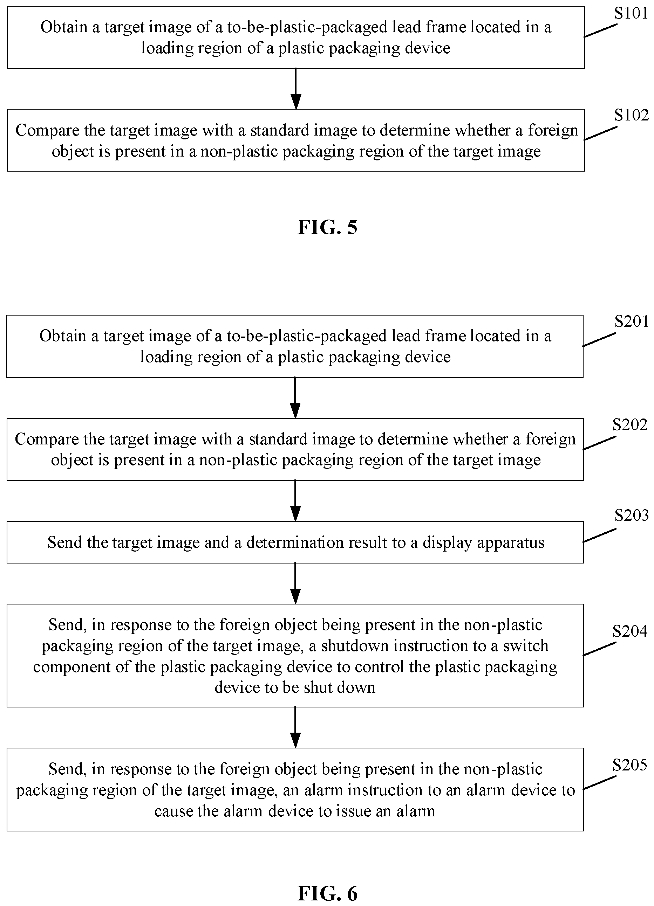

Referring to FIG. 5, a foreign object detection method before semiconductor plastic packaging is further provided according to the present disclosure. The method includes step S101 to step S102.

In step S101, a target image of a to-be-plastic-packaged lead frame located in a loading region of a plastic packaging device is obtained.

In this embodiment, a manner for obtaining the target image of the to-be-plastic-packaged lead frame is not limited and depends on situations. For example, the target image may be obtained via a wired manner or via a wireless manner. Herein, the wireless manner includes, but is not limited to, Bluetooth transmission and WiFi transmission.

In this embodiment, the target image of the to-be-plastic-packaged lead frame located in the loading region is captured and detected, which is completed before plastic packaging, without an individual device or process.

In step S102, the target image is compared with a standard image to determine whether a foreign object is present in a non-plastic packaging region of the target image.

The standard image is an image of a lead frame without any foreign objects (such as displaced or scattered chips or adhering foreign materials).

In an embodiment, the comparing the target image with a standard image to determine whether a foreign object is present in a non-plastic packaging region of the target image includes:
locating a frame connecting rib of the to-be-plastic-packaged lead frame in the target image to determine the non-plastic packaging region; and
comparing the non-plastic packaging region of the target image with the standard image to determine whether the foreign object is present in the non-plastic packaging region.

The to-be-plastic-packaged lead frame is fixed, and determination of the location of the frame connecting rib indicates determination of the location of the non-plastic packaging region, that is, the location of a detection region on the to-be-plastic-packaged lead frame.

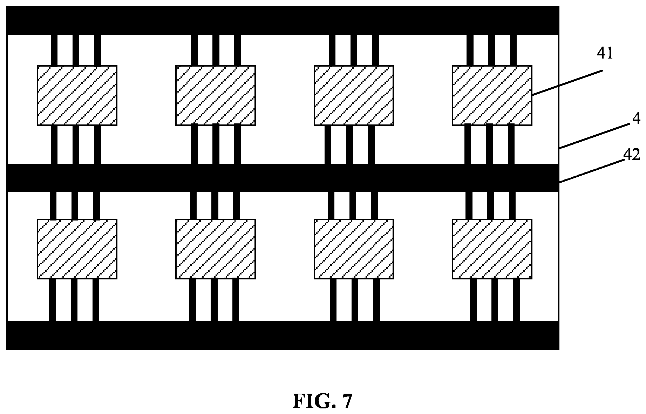

As shown in FIG. 7, the to-be-plastic-packaged lead frame 4 includes a chip 41 and the frame connecting rib 42. A region where the chip 41 is located is a non-detection region, and a region other than the non-detection region is the detection region.

Herein, before locating the frame connecting rib in the target image of the to-be-plastic-packaged lead frame, the foreign object detection method may further include: visual localization for determining the to-be-plastic-packaged lead frame in an image.

The process of comparing the target image with the standard image to determine whether the foreign object is present in the non-plastic packaging region of the target image may be implemented using a Golden Unit model, enabling a comprehensive comparison of foreign objects outside a cavity and preventing missed detection.

In an embodiment, the foreign object detection method may further include:
sending the target image and a determination result to a display apparatus.

In the foreign object detection method in this embodiment, the target image of the to-be-plastic-packaged lead frame located in the loading region is obtained, that is, the image of the to-be-plastic-packaged lead frame before plastic packaging is captured, and then the target image is compared with the standard image to determine whether the foreign object is present in the non-plastic packaging region. The foreign object detection is automatically completed without manual operation, thus saving labor costs. Moreover, any contact with the to-be-plastic-packaged lead frame is avoided during the foreign object detection, and other anomalies in the to-be-plastic-packaged lead frame are avoided during the foreign object detection.

Based on the above embodiments, in an embodiment of the present disclosure, the foreign object detection method may further include:
in response to the foreign object being present in the non-plastic packaging region of the target image, sending a shutdown instruction to a switch component of the plastic packaging device to control the plastic packaging device to be shut down.

After the plastic packaging device is shut down, the personnel handle the to-be-plastic-packaged lead frame with the foreign object and clear the foreign object, thereby ensuring that the mold is not damaged.

Based on any of the above embodiments, in an embodiment of the present disclosure, referring to FIG. 6, the foreign object detection method includes step S201 to step S205.

In step S201, a target image of a to-be-plastic-packaged lead frame located in a loading region of a plastic packaging device is obtained.

In step S202, the target image is compared with a standard image to determine whether a foreign object is present in a non-plastic packaging region of the target image.

In step S203, the target image and a determination result are sent to a display apparatus.

In step S204, in response to a foreign object being present in the non-plastic packaging region of the target image, a shutdown instruction is sent to a switch component of the plastic packaging device to control the plastic packaging device to be shut down.

In step S205, in response to a foreign object being present in the non-plastic packaging region of the target image, an alarm instruction is sent to an alarm device to cause the alarm device to issue an alarm.

In this embodiment, the way of the alarm is not limited and depends on situations. For example, the alarm may be any one or any combination of a sound alarm, a light alarm, and a text alarm.

It should be noted that an execution order of the step S204 and the step S205 is not limited.

In this embodiment, in response to the foreign object being present on the to-be-plastic-packaged lead frame, the alarm device is controlled to issue the alarm to timely notify the personnel that the foreign object is present on the to-be-plastic-packaged lead frame, so that the personnel handle the to-be-plastic-packaged lead frame with the foreign object in the loading region and clear the foreign object, thereby ensuring that the mold is not damaged.

The above embodiments in the specification are described in a progressive manner. Each of the embodiments is mainly focused on describing its differences from other embodiments, and reference may be made among these embodiments with respect to the same or similar parts.

The semiconductor plastic packaging system and the foreign object detection method according to the present disclosure have been described in detail above. The principle and the embodiments of the present disclosure are described by specific examples. The above embodiments are described to facilitate understanding the method and the core idea of the present disclosure. It should be noted that, for those skilled in the art, several improvements and modifications may be made to the present disclosure without departing from the principle of the present disclosure, and these improvements and modifications also fall within the protection scope of the claims of the present disclosure.

## Claims

1. A semiconductor plastic packaging system, comprising a plastic packaging device and a foreign object detection apparatus, wherein
the foreign object detection apparatus comprises an image capturing device and a controller;
the image capturing device is configured to capture a target image of a to-be-plastic-packaged lead frame located in a loading region, wherein the loading region is located in the plastic packaging device; and
the controller is configured to preset a standard image, and compare the target image with the standard image to determine whether a foreign object is present in a non-plastic packaging region of the target image.

2. The semiconductor plastic packaging system according to claim 1, wherein the controller is configured to determine the non-plastic packaging region from the target image and perform comparison with the standard image.

3. The semiconductor plastic packaging system according to claim 1, wherein the controller is configured to compare the non-plastic packaging region of the target image with a non-plastic packaging region of the standard image.

4. The semiconductor plastic packaging system according to claim 1, wherein the controller is connected to a switch component of the plastic packaging device, and in response to the foreign object being present in the non-plastic packaging region of the target image, the controller is further configured to send a shutdown instruction to the switch component to control the plastic packaging device to be shut down.

5. The semiconductor plastic packaging system according to claim 1, further comprising:
an alarm device connected to the controller, wherein the alarm device is configured to receive an alarm instruction from the controller and issue an alarm in response to the foreign object being present in the non-plastic packaging region of the target image.

6. The semiconductor plastic packaging system according to claim 1, further comprising:
a display apparatus connected to the controller, wherein the display apparatus is configured to display the target image and a determination result.

7. The semiconductor plastic packaging system according to any one of claims 1 to 6, wherein a resolution of the image capturing device is above 20 million pixels.

8. A foreign object detection method before semiconductor plastic packaging, comprising:
obtaining a target image of a to-be-plastic-packaged lead frame located in a loading region of a plastic packaging device; and
comparing the target image with a standard image to determine whether a foreign object is present in a non-plastic packaging region of the target image.

9. The foreign object detection method according to claim 8, further comprising:
in response to the foreign object being present in the non-plastic packaging region of the target image, sending a shutdown instruction to a switch component of the plastic packaging device to control the plastic packaging device to be shut down.

10. The foreign object detection method according to claim 8, further comprising:
in response to the foreign object being present in the non-plastic packaging region of the target image, sending an alarm instruction to an alarm device to cause the alarm device to issue an alarm.

11. The foreign object detection method according to claim 8, further comprising:
sending the target image and a determination result to a display apparatus.

12. The foreign object detection method according to any one of claims 8 to 11, wherein the comparing the target image with a standard image to determine whether a foreign object is present in a non-plastic packaging region of the target image comprises:
locating a frame connecting rib of the to-be-plastic-packaged lead frame in the target image to determine the non-plastic packaging region; and
comparing the non-plastic packaging region of the target image with the standard image to determine whether the foreign object is present in the non-plastic packaging region.
